# EUROPEAN PATENT APPLICATION

(11) **EP 0 978 881 A2**
(43) Date of publication of application: **09.02.2000**
(21) Application number: 99114608.5
(22) Date of filing: 26.07.1999
(51) Int. Cl.: H01L 29/92, H01L 21/02, H01G 4/00

(54) **Ferroelectric capacitor and its manufacturing method**

(30) Priority: 07.08.1998 JP 22393398
(71) Applicant: Matsushita Electronics Corporation, Takatsuki-shi, Osaka 569-1193 (JP)
(72) Inventor: Uemoto, Yasuhiro, Otsu-shi, Shiga, 520-0837 (JP); Nagano, Yoshihisa, Suita-shi, Osaka 565-0863 (JP); Fujii, Eiji, Ibaraki-shi, Osaka, 567-0832 (JP)
(74) Representative: Kügele, Bernhard

(57) **Abstract**

A highly reliable semiconductor device having capacitors employing a ferroelectric film and its manufacturing method. After forming an access transistor 2, bit line 6, and first interlayer insulating film 4 on a semiconductor substrate 1, a plug 8 is provided in a contact hole formed at a specified area of the first interlayer insulating film 4 so as to electrically connect the access transistor 2 with the ferroelectric capacitor 9. Then, a bottom electrode 10 made of a multi layered metal film, ferroelectric film 11, and first top electrode 14 are formed in this order, and processed into a required shape. An insulating film 16 for a side wall 16S made such as of a silicon oxide film is formed on an entire wafer surface, and then the entire surface of the insulating film 16 for the side wall 16S is etched anisotropically to form the side wall 16S. Lastly, a second top electrode 17 made typically of Pt is formed and processed to complete a ferroelectric capacitor 9.

## Description

### FIELD OF THE INVENTION

The present invention relates to the field of semiconductor devices having capacitors employing a ferroelectric film, and their manufacturing method. More particularly, the present invention relates to stacked capacitor type memory devices.

### BACKGROUND OF THE INVENTION

The market demand for higher integration of non-volatile semiconductor memory devices having low power consumption and high-speed operation is further increasing in response to the recent advancement of digital technology and significantly improved performance of mobile equipment. Ferroelectric materials have the characteristic of storing information provided from an external electric field at high speed by displacement of constitutional atoms, and continue to store the information even if the external electric field is switched off. Highly reliable semiconductor devices can be realized by employing the ferroelectric material as the dielectric film for capacitors in semiconductor device.

Japanese Laid-open Patents Nos. H6-132482 and H9-116123 disclose a highly integrated semiconductor memory device having a structure of stacked capacitor type memory devices, which employs this ferroelectric material as the dielectric film for its capacitors.

A conventional ferroelectric non-volatile semiconductor memory device and its manufacturing method are described next with reference to a drawing.

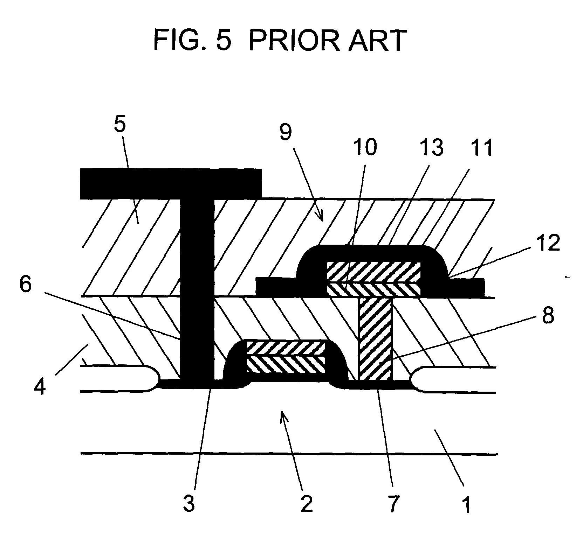

As shown in Fig. 5, the ferroelectric non-volatile semiconductor memory device comprises a semiconductor substrate 1, access transistor 2 formed on the semiconductor substrate 1, source region 3 of the access transistor 2, first interlayer insulating film 4, second interlayer insulating film 5, bit line 6 electrically connected to the source region 3 through a contact hole provided on the first interlayer insulating film 4 and second interlayer insulating film 5, and ferroelectric capacitor 9 electrically connected to a drain region 7 of the access transistor 2 by a plug 8. A ferroelectric film 11 is formed on a bottom electrode 10 for the ferroelectric capacitor 9, and a side wall 12 made of an insulating film is provided at the side of the bottom electrode 10 and ferroelectric film 11. A top electrode 13 is formed over the ferroelectric film 11 and side wall 12 in a way to directly cover them.

However, in the prior art, the side wall 12 is formed by etching the bottom electrode 10 and ferroelectric film 11 of the ferroelectric capacitor 9, and then depositing an insulating film, which will become the side wall 12, over the entire surface by means of the CVD (chemical vapor deposition) method. The entire surface of this insulating film is then etched anisotropically to form the side wall 12 at the side of the bottom electrode 10 and ferroelectric film 11.

With the above method, however, the entire surface of the ferroelectric film 11, which is made of a metal oxide material, is damaged by the anisotropic etching, causing significant irregularity in the composition or disorder in the crystal structure.

Another point is that if a SrBi₂Ta₂O₉ film is used for the ferroelectric film 11 and a silicon oxide film is used for the side wall 12 which is the insulating film, and if the silicon oxide film is etched anisotropically using an etching gas such as CF₄, the surface of the SrBi₂Ta₂O₉ film, which is the ferroelectric film 11, is exposed after anisotropic etching, but silicon oxide film may remain on the ferroelectric film 11.

If the silicon oxide film remains on the ferroelectric film 11, the structure of the ferroelectric capacitor becomes the top electrode 13, silicon oxide film, ferroelectric film 11, and bottom electrode 10, instead of the intended structure of the top electrode 13, ferroelectric film 11, and bottom electrode 10. Voltage applied between the top electrode 13 and bottom electrode 10 is also distributed to the remaining silicon oxide film connected in series to the ferroelectric film 11. This reduces the voltage applied to the ferroelectric film 11, causing reduction of residual electric charge, a defect in its characteristics, due to insufficient polarization inversion of the ferroelectric film 11.

To prevent any silicon oxide film remaining on the ferroelectric film 11, over-etching, taking into account the deviation of the etching rate of the silicon oxide film inside the wafer surface and deviation of deposited amount of the silicon oxide film inside the wafer surface, may be required when etching the silicon oxide film.

It has been experimentally confirmed that over-etching causes an oxygen deficit because the entire surface of the SrBi₂Ta₂O₉ film, the ferroelectric film 11, is exposed to the etching plasma directed at the silicon oxide film. Furthermore, a deficit of the main constitutional atoms of the ferroelectric film 11, such as Bi and Ta, is observed.

Such damage may not be recoverable by post-processing such as heat treatment, and would appear to prevent the formation of a ferroelectric capacitor with good electrical characteristics. Consequently, it may be difficult to manufacture a highly reliable ferroelectric non-volatile semiconductor memory device.

### SUMMARY OF THE INVENTION

A semiconductor device having a capacitance element including a top electrode, an insulating film and a bottom electrode, said semiconductor device comprising: a passivation film for said insulating film between said insulating film and said top electrode; and a side wall formed at least at the side of said insulating film and said passivation film for said insulating film.

A semiconductor device having a capacitance element including an insulating film made of a ferroelectric film between a top electrode and a bottom electrode, said semiconductor device comprising: a passivation film for said ferroelectric film between said ferroelectric film and said top electrode; and a side wall formed at least at the side of said ferroelectric film and said passivation film for said ferroelectric film.

This configuration prevents the surface of the ferroelectric film from being exposed to plasma and damaged during formation of the side wall because the passivation film for ferroelectric film covers the surface of the ferroelectric film. Accordingly, deterioration in electrical characteristics of the ferroelectric film may be eliminated, resulting in a ferroelectric capacitor with good ferroelectric and insulation characteristics.

In addition, even if the first top electrode as a passivation film for ferroelectric film is damaged during formation of the side wall, the second top electrode formed on the first top electrode will prevent any deterioration in electrode performance.

### BRIEF DESCRIPTION OF THE DRAWINGS

Fig. 1 is a schematic cross-sectional view of a semiconductor device in accordance with a preferred embodiment of the present invention.
Figs. 2A to 2G are schematic cross-sectional views of the process flow sequence for manufacturing the semiconductor device in accordance with the preferred embodiment of the present invention.
Fig. 3 is a comparison graph illustrating the hysteresis characteristics of a ferroelectric capacitor in the semiconductor device in accordance with the preferred embodiment of the present invention and a conventional semiconductor device.
Fig. 4 is a comparison graph illustrating the current-voltage characteristics of the ferroelectric capacitor in the semiconductor device in accordance with the preferred embodiment of the present invention and the conventional semiconductor device.
Fig. 5 is a schematic cross-sectional view of a part of the conventional semiconductor device.

### DESCRIPTION OF THE PREFERRED EMBODIMENT

A preferred embodiment of a semiconductor device in accordance with a preferred embodiment of the present invention is described with reference to drawings.

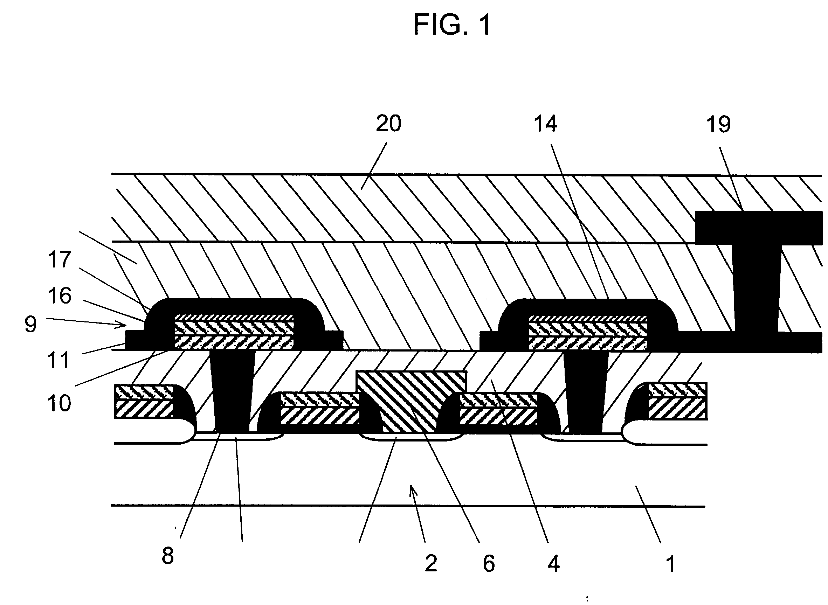

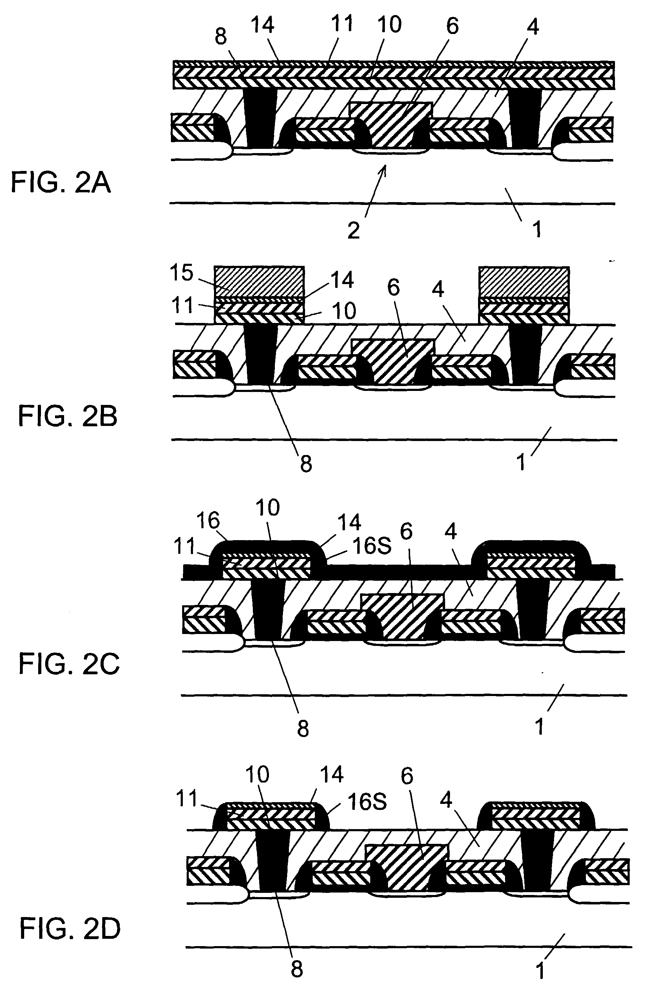

Fig. 1 shows a schematic cross-sectional view of a relevant part of the semiconductor device in the preferred embodiment of the present invention. Figs. 2A to 2G are schematic cross-sectional views of the process flow sequence illustrating a method for manufacturing the semiconductor device in the preferred embodiment of the present invention.

As shown in Fig. 2A, an access transistor 2 is formed on a semiconductor substrate 1 as an integrated circuit, and then a bit line 6 typically made of a polycide film is formed. A first interlayer insulating film 4 made of a material such as BPSG is formed on the access transistor 2 and bit line 6. Then, a contact hole is formed at a specified area on the first interlayer insulating film 4. A plug 8 is provided in the contact hole to electrically connect the access transistor 2 and a ferroelectric capacitor 9 (Fig. 1). The plug 8 is formed by embedding polysilicon or tungsten in the contact hole and then removing the polysilicon or tungsten deposited outside the contact hole by the etch-back method or chemical mechanical method.

A bottom electrode 10, constituted of an approximately 200 nm thick multi-layered film formed by successively depositing an adhesion layer, barrier metal, and Pt, is formed over the entire surface of the wafer. Then, a layer approximately 150 nm thick of a ferroelectric film 11 made of SrBi₂Ta₂O₉ is formed by the spin coating or CVD method. An approximately 50 nm thick first top electrode 14 made of multi-layer metal containing of Pt is deposited.

As shown in Fig. 2B, the first top electrode 14, ferroelectric film 11, and bottom electrode 10 are dry-etched by mixed gas such as Ar and Cl, using a bottom electrode processing mask 15 made for example of photo resist. These are all processed into approximately the same shape to form the ferroelectric capacitor 9 (Fig. 1).

Then, as shown in Fig. 2C, after removing the bottom electrode processing mask 15, made for example of photo resist, typically by ashing, an approximately 300 nm thick insulating film 16 for a side wall 16S made typically of silicon oxide film is formed over the entire wafer surface.

As shown in Fig. 2D, the entire surface of the insulating film 16 for the side wall 16S formed on the entire surface of the wafer is etched anisotropically using etching gas such as CF₄ to complete the side wall 16S.

The key point here is that the surface of the ferroelectric film 11 is not exposed to plasma during anisotropic etching of the insulating film 16 for the side wall 16S because the first top electrode 14 covers the surface of the ferroelectric film 11 as a passivation film for the ferroelectric film. Accordingly, the surface of the ferroelectric film 11 is not damaged, and this preserves the good electrical characteristics of the ferroelectric film 11.

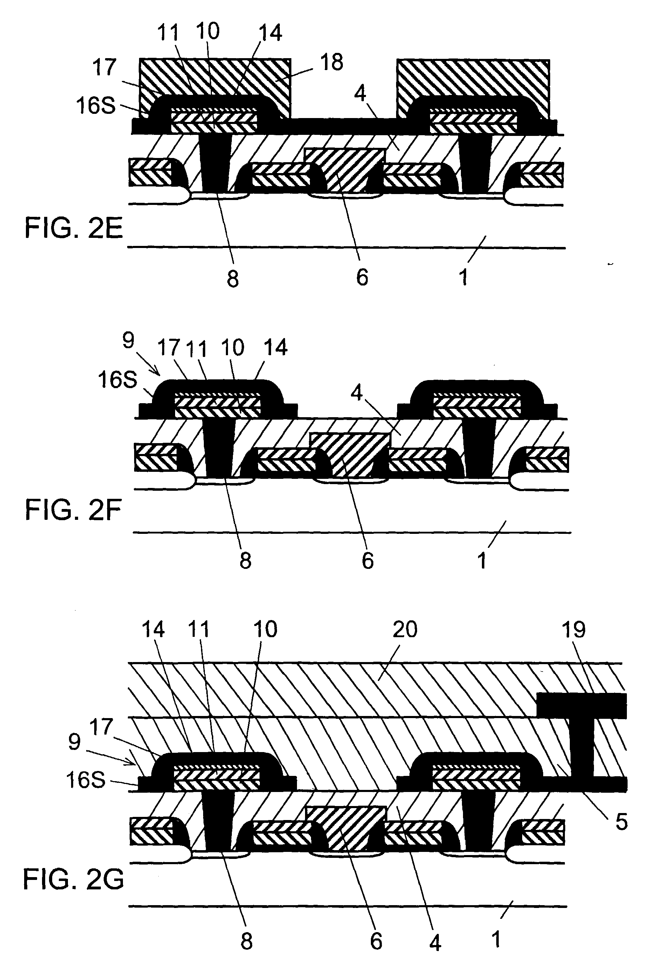

As shown in Fig. 2E, a 100 nm thick second top electrode 17 made typically of Pt is deposited over the entire surface of the wafer, and then a top electrode processing mask 18, made typically of photo resist, is formed. The second top electrode 17 may be formed after the first top electrode 14 is etched off In this case however the first top electrode 14 does not work as a passivation film for the ferroelectric film.

As shown in Fig. 2F, the second top electrode 17 is formed using the top electrode processing mask 18 made typically of photo resist by dry etching with mixed gas such as Ar and Cl. The second top electrode 17 is formed to cover the entire first top electrode 14 on the ferroelectric film 11, or is formed to cover the first top electrode 14 on the ferroelectric film 11 and the side wall 16s in a way to cover the entire surface. And this second top electrode 17 is also formed in a way to be thicker compared to the first top electrode 14. This completes the ferroelectric capacitor 9. The reason why the thickness of the first top electrode 14 can be thinner than the thickness of the second top electrode 17 is that the first top electrode 14 should have such a thickness that the surface of the ferroelectric film 11 is not damaged in the process of the anisotropic etching.

Lastly, as shown in Fig. 2G, a second interlayer insulating film 5 is formed on the semiconductor substrate 1 having this ferroelectric capacitor 9. Inter-connection 19, made for example of Al film, formed on the second interlayer insulating film 5 reaches the second top electrode 17 and bit line 6 through the contact hole formed at a specified area of the second interlayer insulating film 5. A silicon nitride film 20 is formed as a final passivation film, completing the construction of the ferroelectric non-volatile semiconductor memory device.

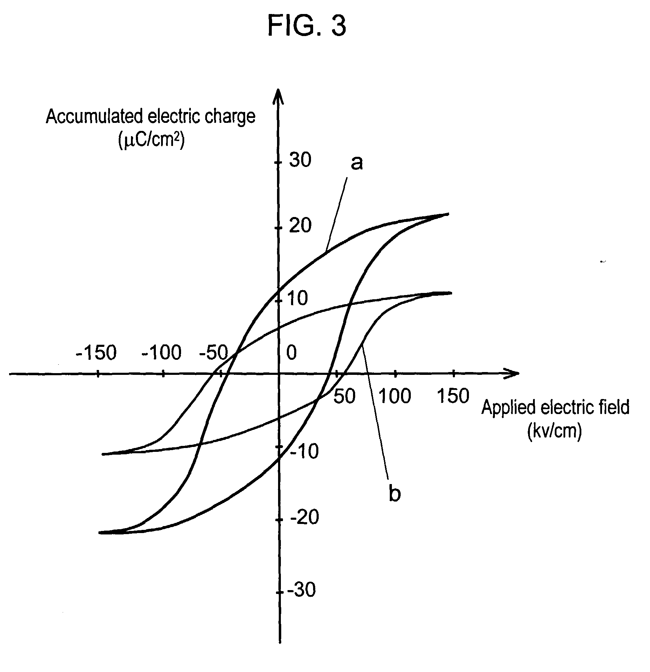

Fig. 3 shows the hysteresis characteristics of the ferroelectric capacitor used in the ferroelectric non-volatile semiconductor memory device in the preferred embodiment (Curve a) compared with that used in the conventional ferroelectric non-volatile semiconductor memory device (Curve b).

The data measuring method used in Fig. 3 is the Sawyer-Tower circuit method for example: a pulse of an appropriate electric field is applied between the top and bottom electrodes of the ferroelectric capacitor to evaluate its hysteresis characteristics in accumulated electric charge against applied electric field.

Fig. 3 shows the measurement results when an electric field of 150 kV/cm to -150 kV/cm is applied to the ferroelectric capacitor. It is apparent from Fig. 3 that, for a ferroelectric non-volatile semiconductor memory device using a conventional ferroelectric capacitor, the difference in accumulated electric charge is 11 µC/cm² when the applied electric field is 0 kV/cm. For the ferroelectric non-volatile semiconductor memory device using the ferroelectric capacitor in the preferred embodiment of the present invention, the difference in accumulated electric charge is the much improved value of 22 µC/cm². Accordingly, the hysteresis characteristics of the ferroelectric capacitor in the preferred embodiment of the present invention result in a larger accumulated electric charge than that of the conventional ferroelectric capacitor, giving the preferred embodiment of the present invention significantly better memory characteristics.

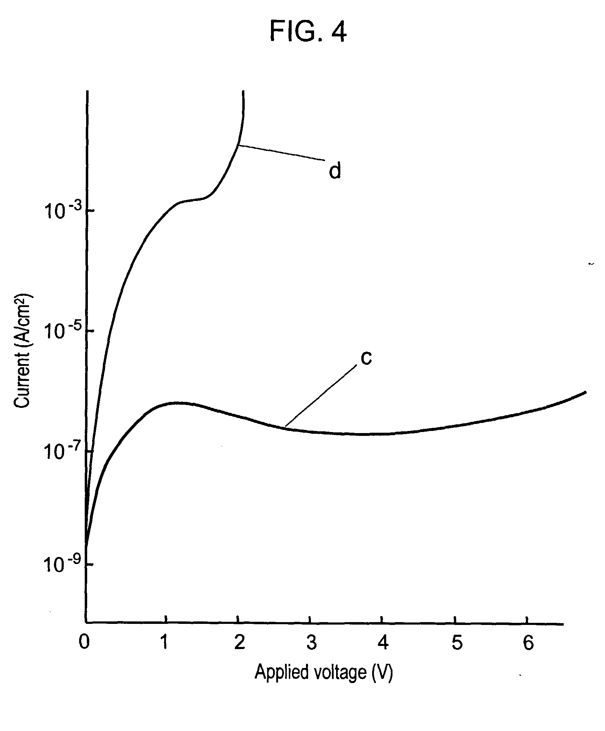

Fig 4 shows a comparison of the current-voltage characteristics of ferroelectric capacitors. Curve c in Fig. 4 illustrates the current-voltage characteristics of the ferroelectric non-volatile semiconductor memory device in the preferred embodiment, and Curve d shows the current-voltage characteristics of the conventional ferroelectric non-volatile semiconductor memory device.

In Fig. 4, data is measured by applying voltages ranging from 0 V to 6 V between the top and bottom electrodes of the ferroelectric capacitor, and measuring the current flowing through the ferroelectric capacitor to evaluate its current-voltage characteristics.

It is apparent from Fig. 4 that the current flowing through the ferroelectric capacitor exceeds 10⁻³ A/cm² when the conventional ferroelectric non-volatile semiconductor memory device is used. When the ferroelectric non-volatile semiconductor memory device in the preferred embodiment of the present invention is used, current flowing through the ferroelectric capacitor is a maximum of 10⁻⁶ A/cm² . This indicates that the leak current under applied voltage is extremely low, demonstrating the good insulation performance of the ferroelectric film.

In the preferred embodiment, the ferroelectric film 11 is used as an insulating film between the top electrodes 14, 17 and the bottom electrode 10. The good insulation characteristics can also be obtained by using an ordinary insulating film made of SiO₂ film and the like.

In the preferred embodiment, SrBi₂Ta₂O₉ is used for the ferroelectric film 11. The same effect is also achievable by using SrBi₂Nb₂O₉, which substitutes Nb for Ta; a mixture of both materials, or different compound ratio of Sr, Bi, and Ta can also be used. Other ferroelectric materials such as a PZT film are also applicable for achieving the same effect.

For the ferroelectric film 11, a ferroelectric film having a bismuth layer perovskite structure is preferable.

The preferred embodiment describes the case when the bit line 6 is formed at a lower layer than the ferroelectric capacitor 9. The same effect is achievable with a structure comprising the bit line 6 formed at a layer above the ferroelectric capacitor 9.

In the preferred embodiment, a multi-layered film deposited in the order of adhesion layer, barrier metal, and Pt is used for the bottom electrode 10. The same effect is achievable by using at least Pt or a multi-layered film containing Pt and iridium oxide.

The preferred embodiment employs Pt for the first top electrode 14 and second top electrode 17. The same effect is also achievable by using at least Pt or a multi-layered film of Pt and iridium oxide.

The preferred embodiment illustrates an example, as shown in Figs. 1 and 2G, where the inter-connection 19 made typically of Al film is connected to the second top electrode 17 at a single point. Since the second top electrode 17 electrically connects to more than one ferroelectric capacitor 9, the inter-connection 19 is connected to more than one ferroelectric capacitors 9 if the inter-connection 19 is connected to the second top electrode 17 at a single point. However, the inter-connection 19 can be also connected to the second top electrode 17 at more than one point.

Thickness ranges in the present invention are not limited to those described in the above preferred embodiment. The following ranges are preferable.
- Thickness of the bottom electrode 10: 50 nm - 300 nm
- Thickness of the ferroelectric film 11 made of SrBi₂Ta₂O₉: 50 nm -300 nm
- Thickness of the first top electrode 14 made of Pt: 20 nm - 100 nm
- Thickness of the insulating film 16 for the side wall 16S made typically of silicon oxide film: 100 nm - 500 nm
- Thickness of the second top electrode 17 made typically of Pt: 50 nm - 300 nm

As described above, the first top electrode covers the surface of the ferroelectric film in the present invention. This prevents the surface of the ferroelectric film from being exposed to plasma and damaged during anisotropic etching of the insulating film to form the side wall.

Accordingly, the present invention offers a ferroelectric capacitor with good ferroelectric and insulation characteristics without degrading the electrical characteristics of the ferroelectric film. This enables the formation of a highly reliable ferroelectric non-volatile semiconductor memory device.

### Reference numerals

- 1: semiconductor substrate
- 2: access transistor
- 3: source region
- 4: first interlayer insulating film
- 5: second interlayer insulating film
- 6: bit line
- 7: drain region
- 8: plug
- 9: ferroelectric capacitor
- 10: bottom electrode
- 11: ferroelectric film
- 14: first top electrode
- 16: insulating film for side wall
- 16S: side wall
- 17: second top electrode
- 19: inter-connection
- 20: passivation film

## Claims

1. A semiconductor device having a capacitance element including a top electrode, an insulating film and a bottom electrode, said semiconductor device comprising:
a passivation film for said insulating film between said insulating film and said top electrode;
and a side wall formed at least at the side of said insulating film and said passivation film for said insulating film.

2. A semiconductor device having a capacitance element including an insulating film made of a ferroelectric film between a top electrode and a bottom electrode, said semiconductor device comprising:
a passivation film for said ferroelectric film between said ferroelectric film and said top electrode;
and a side wall formed at least at the side of said ferroelectric film and said passivation film for said ferroelectric film.

3. The semiconductor device as defined in Claim 2, wherein said passivation film for said ferroelectric film is made of conductive material.

4. The semiconductor device as defined in Claim 3, wherein said passivation film for said ferroelectric film is made of the same material as said top electrode.

5. The semiconductor device as defined in Claim 4, wherein said top electrode is a multi-layered film including Pt or Pt and iridium oxide.

6. The semiconductor device as defined in Claim 2, wherein said ferroelectric film has a bismuth layer perovskite structure.

7. A method for manufacturing a semiconductor device, comprising the steps of:
forming a bottom electrode, a ferroelectric film and a passivation film for said ferroelectric film into a specified shape;
forming a side wall at least at the side of said ferroelectric film and said passivation film for said ferroelectric film by anisotropic etching; and
forming a top electrode on said side wall and passivation film for said ferroelectric film.

8. The method for manufacturing semiconductor devices as defined in Claim 7, wherein the step of forming a bottom electrode, a ferroelectric film and a passivation film for said ferroelectric film into a specified shape comprising the steps of:
forming said bottom electrode;
depositing a ferroelectric film and a passivation film for said ferroelectric film sequentially on said bottom electrode; and
patterning said bottom electrode, said ferroelectric film and said passivation film for said ferroelectric film into substantially the same shape.

9. A method for manufacturing semiconductor device comprising the steps of:
forming a first insulating film on a substrate fabricated with semiconductor integrated circuit;
forming a plug connected to a source region or a drain region of said semiconductor integrated circuit, in a contact hole formed at a specified area of said first insulating film;
forming a bottom electrode connected to said plug;
forming a ferroelectric film and a passivation film for said ferroelectric film into a specified shape on said bottom electrode;
forming a side wall at the side of said ferroelectric film and said passivation film for said ferroelectric film by anisotropic etching;
and forming a top electrode on said side wall and said passivation film for said ferroelectric film.

10. The method for manufacturing semiconductor device as defined in Claim 9, after said step of forming a side wall at the side of said ferroelectric film and said passivation film for said ferroelectric film by anisotropic etching, said method further comprising the steps of;
removing the remains of etching on the surface of said passivation film for said ferroelectric film before forming a top electrode on said side wall and said passivation film for said ferroelectric film.
